# EUROPÄISCHE PATENTSCHRIFT

(11) **EP 1 333 263 B1**
(45) Veröffentlichungstag und Bekanntmachung des Hinweises auf die Patenterteilung: **02.11.2006**
(21) Anmeldenummer: 02002465.9
(22) Anmeldetag: 01.02.2002
(51) Int. Cl.: G01L 5/00, G01N 3/00, G01N 19/04, H01L 21/66

(54) **Testvorrichtung zur Ausführung eines Pulltests**
Device for carrying out a pull-test
Dispositif d'essais en tirage de connections

(43) Veröffentlichungstag der Anmeldung: 06.08.2003
(73) Patentinhaber: F & K Delvotec Bondtechnik GmbH, 85521 Ottobrunn (DE)
(72) Erfinder: Farassat, Farhad, Dr., 82024 Taufkirchen (DE)
(74) Vertreter: Popp, Eugen

(56) Entgegenhaltungen:
- EP-A- 0 772 036
- WALTER P: "BOND TESTING ENTERS MAINSTREAM PCB ASSEMBLY" MICROELECTRONICS JOURNAL, MACKINTOSH PUBLICATIONS LTD. LUTON, GB, Bd. 27, Nr. 1, 1. Februar 1996 (1996-02-01), Seiten I-V, XP000587917 ISSN: 0026-2692
- SHANKARA PRASAD ET AL: "AN IMPROVED WIRE BOND PULL TEST" SOLID STATE TECHNOLOGY, COWAN PUBL.CORP. WASHINGTON, US, Bd. 34, Nr. 6, 1. Juni 1991 (1991-06-01), Seiten 39-41, XP000216771 ISSN: 0038-111X
- PERLBERG G ET AL: "WIRE BOND PULL TESTING UNDERSTANDING THE GEOMETRIC RESOLUTION OF FORCES" ADVANCED PACKAGING, IHS PUBLISHING GROUP, US, Bd. 3, Nr. 1, 1994, Seiten 21-22, XP000469456 ISSN: 1065-0555

## Beschreibung

Die Erfindung betrifft eine Testvorrichtung zur Ausführung eines sogenannten Pulltests (Scher-Zug-Test) zur Bestimmung der Zugfestigkeit einer Drahtbondverbindung nach dem Oberbegriff des Anspruchs 1.

Die Scher-Zug-Prüfung ist das seit längerem am häufigsten eingesetzte Verfahren zur Testung von Drahtbondverbindungen. Bei diesem Verfahren wird ein kleiner Zughaken unter eine zwischen zwei Bondkontakten ausgebildete Drahtschlaufe (Loop) gebracht und mit konstanter Geschwindigkeit senkrecht zur Substratoberfläche von dieser weg (in der Regel also nach oben) gezogen, bis die Bonddrahtschlaufe reißt oder eine eingestellte Kraft erreicht ist. Die momentane Zugkraft wird mit einer Kraftmesseinrichtung gemessen und der Zugkraftwert beim Zerreisen der Bonddrahtschlaufe als Abreißkraft registriert, die Auskunft über die Qualität der Bondverbindung gibt.

Mit diesem Verfahren lassen sich z. B. Schwächungen des Drahtes im Heelbereich oder die Schweißqualität sehr gut erkennen. Die Ergebnisse der Testung werden mit in einschlägigen Qualitätsvorschriften (etwa MIL-STD883 Methode 2011) festgelegten Mindestzugfestigkeiten für Drahtbondverbindungen verglichen.

Bekannte Testvorrichtungen zur Durchführung dieses Verfahrens, bei denen die Kraftmessung üblicherweise über die zugkraftbedingte Deformation eines Auslegers gemessen wird, an dem der Zughaken befestigt ist, haben sich unter bestimmten Aspekten als nachteilig erwiesen. So erscheint insgesamt die Genauigkeit der Messungen als verbesserungsbedürftig, und es haben sich Probleme bei der Reproduzierbarkeit unter wechselnden Umgebungstemperaturen gezeigt.

Eine Testvorrichtung zur Ausführung eines Pull-tests nach dem Oberbegriff des Anspruchs 1 ist aus EP 0 772 036 A2 bekannt.

Die Veröffentlichung von Paul Walter: _{"}Bond testing enters mainstream PCB assembly", Microelectronics Journal, 27.02.1996, Eksevuer, UK XP00058918, befasst sich mit der Anwendung bekannter Bondtestverfahren in einer PCB-Montagelinie und beschreibt in diesem Zusammenhang auch kurz den sogenannten Pull-Test für Drahtbondverbindungen. Die Veröffentlichung enthält fotografische Abbildungen zum Testablauf und den Hinweis auf eine automatische Positionierung des Zughakens im Ergebnis einer Mustererkennung.

Die Veröffentlichung von G. Perlberg, C. Enman: _{"}Wire Bond Pull Testing", Advanced Packaging, IHS Publishing Group, Bd. 3, Nr. 1, 1994, US, Seiten 21-22; XP000469456, befasst sich mit der Theorie des Pull-Tests für Drahtbondverbindungen und leitet Folgerungen für die praktische Ausführung des Tests ab.

Die Veröffentlichung von S. Pradad, A. Saboui: _{"}An improved wire bond pull test", Solid State Technology, Bd. 24, June 1991, Nr. 6, USA, Seiten 39-41, XP000216771 beschreibt einen verbesserten Pulltest für Drahtbondverbindungen, wobei eine verbesserte Auswertung unter genauer Betrachtung der Spannungsverteilung in den verschiedenen Abschnitten einer Bondverbindung vorgeschlagen wird. Hierbei wird ein Angreifen des Zughakens entweder in der Mitte der Bonddrahtschlaufe oder an deren höchsten Punkt erwähnt.

Der Erfindung liegt die Aufgabe der Bereitstellung einer verbesserten Testvorrichtung der gattungsgemäßen Art zugrunde, die insbesondere genauere und besser reproduzierbare Testergebnisse auch bei wechselnden Umgebungstemperaturen liefern soll.

Diese Aufgabe wird durch eine Testvorrichtung mit den Merkmalen des Anspruchs 1 gelöst

Die Erfindung schließt den wesentlichen Gedanken ein , für ein zuverlässiges Ergreifen der Drahtschlaufe in ihrem höchsten Punkt Sorge zu tragen, um Verfälschungen der Messergebnisse durch von der Senkrechten auf die Substratoberfläche abweichende Kraftkomponenten zu vermeiden. Hierzu werden erfindungsgemäß Erfassungsmittel zum Erfassen des höchsten Punktes der Bonddrahtschlaufe und Positionssteuermittel zur selbsttätigen Positionierung des Zughakens und somit des Anfangspunktes des Zugkraftvektors unter den höchsten Punkt der Bonddrahtschlaufe vorgesehen.

Bevorzugt weist die Kraftmesseinrichtung mindestens eine koaxiale zu einer Antriebsstange des Zughakens angeordnete Kraftmessdose auf. Im Interesse einer weitgehenden Temperaturkompensation besteht die Kraftmesseinrichtung bevorzugt aus einer Kombination (einem Paar) von übereinander angeordneten Kraftmessdosen.

In einer weiteren bevorzugten Ausführung ist eine Luftlagerung der Antriebsstange des Zughakens vorgesehen, um die in herkömmlichen Lagerungen auftretenden und die Genauigkeit der Messergebnisse herabsetzenden Reibungskräfte praktisch zu eliminieren.

In einer weiteren zweckmäßigen Fortbildung des Erfindungsgedankens ist eine Motor-Getriebe-Einheit zur Drehung des Zughakens um die Wirkungsrichtung der Antriebseinrichtung, d.h. zur Festlegung einer vorbestimmten Winkellage des Zughakens um den Zugkraftvektor, vorgesehen. Diese Maßnahme dient einerseits der Erleichterung der Handhabung der Testvorrichtung bei Substraten mit komplexen Bondgeometrien und andererseits dem oben erwähnten Ziel der Erhöhung der Messgenauigkeit, denn sie ermöglicht es, fehlerträchtige Fehlstellungen zwischen Zughaken und Bonddrahtschlaufe zu vermeiden.

Der Erreichung der beiden vorgenannten Vorteile dient auch das Vorsehen eines xy-Tisches zum koordinatengesteuerten Verfahren des Substrates (und damit des höchsten Punktes der Loop, an dem der Zughaken angreifen soll) bezüglich des Zughakens.

Diese Maßnahme ist in engem Zusammenhang zu sehen mit dem Vorsehen einer Kamera, deren Gesichtsfeld seitlich auf die Bonddrahtschlaufe ausgerichtet ist, und einer mit der Kamera verbundenen Bildauswertungseinrichtung zur Berechnung der Koordinaten des höchsten Punktes der Bonddrahtschlaufe aus dem Kamerabild.

In einer weiteren vorteilhaften Ausgestaltung der Erfindung sind dem Zughaken und der Antriebseinrichtung Federmittel zum Vorspannen des Zughakens in eine definierte Ausgangsposition sowie zur Dämpfung des Eingriffs zwischen Zughaken und Bonddrahtschlaufe und/oder zur Zugkraftbegrenzung zum Schutz der Kraftmesseinrichtung zugeordnet. Insbesondere umfassen die Federmittel mindestens eine erste Feder mit niedriger Federkonstante zum Vorspannen in die Ausgangsposition sowie zur Eingriffs-Dämpfung und eine zweite Feder mit hoher Federkonstante zur Zugkraftbegrenzung, wobei beide Federn bevorzugt koaxial zur Antriebsstange angeordnet sind. Hierdurch ergibt sich eine einfach herzustellende und zu wartende Konstruktion, und möglicherweise die Messergebnisse verfälschende Hebelkräfte und Kippmomente werden grundsätzlich ausgeschlossen.

Aus den abhängigen Ansprüchen sowie der nachfolgenden Beschreibung eines bevorzugten Ausführungsbeispiels anhand der Figuren. Von diesen zeigen:
- Fig. 1: in einer schematischen Darstellung eine Bonddrahtschlaufe zur Verdeutlichung des Testprinzips,
- Fig. 2: eine weitere schematische Darstellung zur Illustration der Kraftverläufe bei einem Pulltest,
- Fig. 3: eine Prinzipskizze einer Testvorrichtung gemäss einer Ausführungsform der Erfindung und
- Fig. 4: eine Längsschnittdarstellung des Hauptteils einer Ausführungsform der erfindungsgemäßen Testvorrichtung.

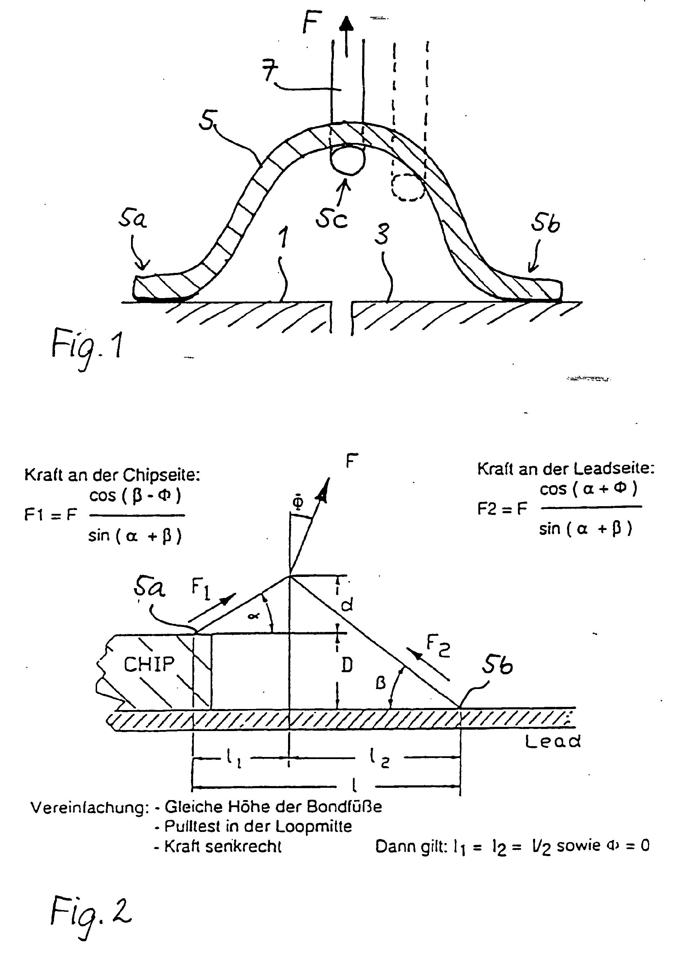

In Fig. 1 ist schematisch ein zwei Bondflächen 1,3 bogenförmig (als "Loop") verbindender Bonddraht 5 dargestellt, unter dem ein Zughaken 7 zur Ausführung des sogenannten Pulltests (auch bekannt als Scher-Zug-Test) positioniert ist. Der Bonddraht 5 hat auf den Bondflächen 1, 3 Kontaktpunkte (Bondkontakte) 5a, 5b. Mit 5c ist der höchste Punkt der Bonddrahtschlaufe bezeichnet. In der Figur ist Zughaken 7 in für die Testung optimalerweise unter dem höchsten Punkt der Loop 5 positioniert; zum Vergleich ist gestrichelt ein seitlich des höchsten Punktes und daher in für die Testung ungünstiger Lage positionierter (nicht bezeichneter) Zughaken skizziert.

Fig. 2 zeigt für den allgemeinen Fall unterschiedlicher Höhe der Bondkontakte die für die Durchführung und Auswertung des Pulltests relevanten Winkel und Kraftvektoren und ist aufgrund der Beschriftung im wesentlichen selbsterklärend. Zur Verdeutlichung der geometrischen Zusammenhänge zwischen Fig. 1 und Fig. 2 sind in Fig. 2 die Bondkontakte 5a, 5b gekennzeichnet; die mit dem (in Fig. 2 nicht dargestellten) Bonddraht verbundenen Komponenten sind hier ein Halbleiterschaltkreis Chip und eine Leitung Lead.

Zu Fig. 2 wird im übrigen auf die obigen allgemeinen Ausführungen zur Scher-Zug-Prüfung hingewiesen.

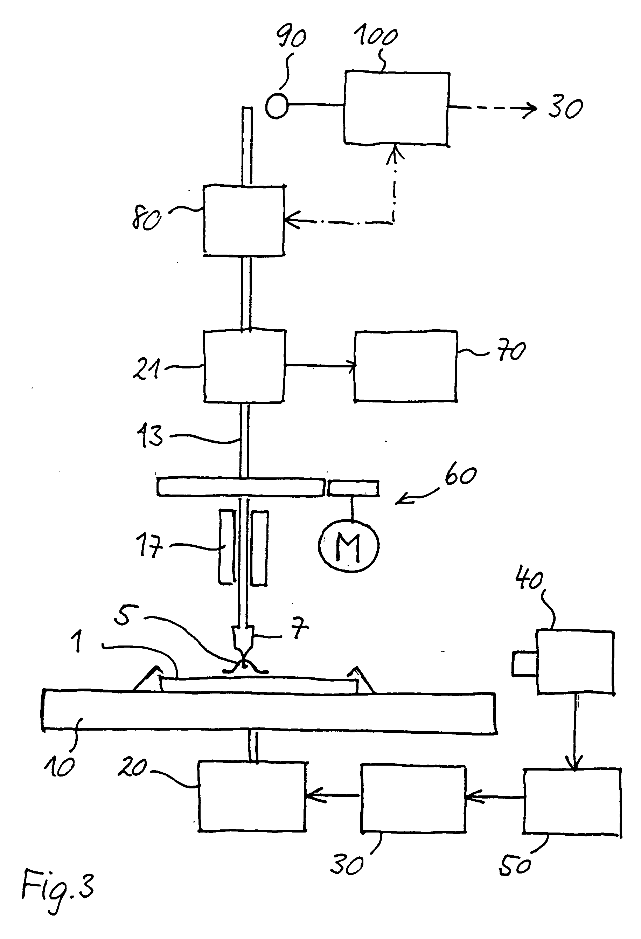

Fig. 3 zeigt in einer Prinzipskizze den grundsätzlichen Aufbau einer Testvorrichtung gemäss einer Ausführungsform der Erfindung zur Zugfestigkeitsprüfung einer Bonddrahtschlaufe 5 auf einem Substrat 1. Das Substrat 1 ist auf einem xy-Tisch 10 fixiert, der durch eine Tischantriebseinheit angetrieben wird, die durch eine Koordinatensteuerstufe 30 gesteuert wird.

Eine CCD-Kamera 40 mit nachgeschalteter Bildauswertungseinrichtung 50 ist seitlich des Substrates 1 angeordnet und nimmt ein Bild der Loop 5 auf. (Die tatsächliche Kameraposition ist in der Figur aus zeichnerischen Gründen nicht korrekt wiedergegeben.) Der Ausgang der Bildauswertungseinrichtung 50 ist mit einem Eingang der Koordinatensteuerstufe 30 verbunden, um dieser die aufgrund des Kamerabildes berechneten Positionskoordinaten des höchsten Punktes der Loop 5 zuzuführen und eine auf diesem Auswertungsergebnis beruhende Verschiebung des xy-Tisches 10 zu ermöglichen.

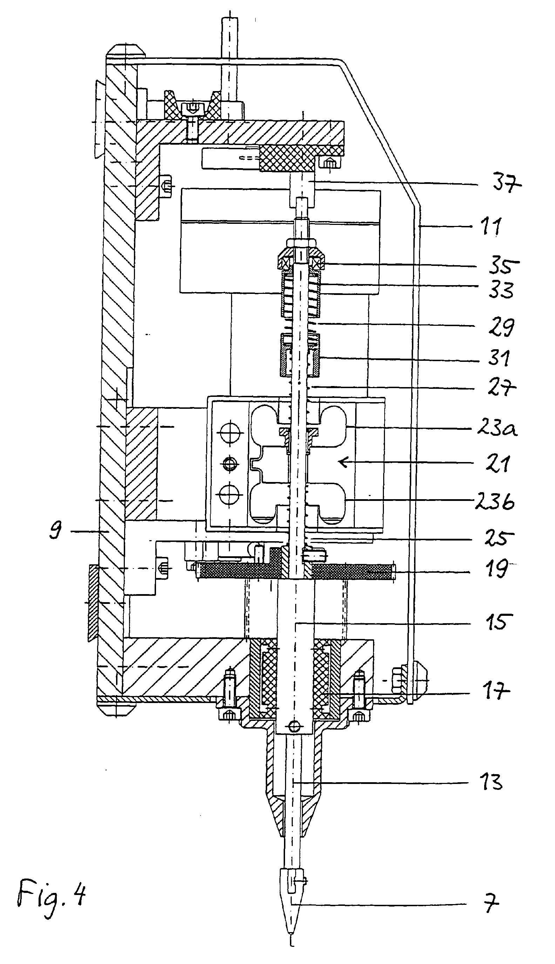

Der Zughaken 7 ist am unteren Ende einer Antriebs- bzw. Messstange 13 angebracht, die in einem Luftlager 17 (welches ebenso wie die Antriebsstange weiter unten genauer beschrieben wird) praktisch reibungsfrei gelagert ist. Eine Motor-Getriebe-Einheit 60 ist zur Winkelverstellung des Zughakens vorgesehen. Der Antriebs- bzw. Messstange 13 ist eine Kraftmesseinrichtung 21 (die ebenfalls weiter unten unter Bezugnahme auf Fig. 4 genauer beschrieben wird) zugeordnet, deren Messsignal einer Registrierungseinheit 70 zugeführt wird. Angetrieben wird die Testvorrichtung durch eine Mess-Antriebseinheit 80.

Dem oberen Ende der Antriebsstange 13 ist ein Bewegungs- bzw. Näherungssensor 90 zugeordnet, der mit einer Steuer- und Auswertungseinheit 100 verbunden ist, die zudem in Steuer- und Messsignalverbindung zur Mess-Antriebseinheit 80 sowie zur Koordinatensteuerstufe 30 steht. Diese dient im Zusammenwirken mit der Koordinatensteuerstufe (und der Tischantriebseinheit 20) sowie der Mess-Antriebseinheit 80 zur Bestimmung der Position des höchsten Punktes anhand der Signale des Bewegungssensors 90 aufgrund der Erfassung von Bewegungen der Antriebsstange (Messstange) 13, die sich aus dem Eingriff des Zughakens 7 mit der Loop 5 ergeben. Weiterhin dient sie zur Ausgabe der Koordinaten des höchsten Punktes an die Koordinatensteuerstufe 30 des xy-Tisches 10, um eine Bewegung des Substrates 1 und damit der Loop 5 zur Erreichung der optimalen Eingriffsposition mit dem Zughaken 7 zu bewerkstelligen.

Fig. 4 zeigt in einer Längsschnittdarstellung wesentliche Teile einer aus derzeitiger Sicht bevorzugten Ausführungsform der erfindungsgemäßen Testvorrichtung. Diese ist auf einer mechanisch stabilen, mehrteiligen Tragkonstruktion 9 aufgebaut und durch eine Abdeckung 11 geschützt. Außerhalb dieser angeordneten Auswertungseinrichtungen und Antriebs- bzw. Versorgungskomponenten sind in der Figur nicht dargestellt; auf diese wird aber in der nachfolgenden Beschreibung hingewiesen.

Der Zughaken 7 ist an einer Antriebsstange 13 befestigt, welche zugleich als Messkraftübertrager ("Messstange") dient und durch eine Luftlagerwelle 15 reibungsfrei in einem Luftlager 17 geführt ist. Hierdurch wird eine besonders reibungsarme Lagerung und infolge dessen eine hohe Genauigkeit der Reißkraftmessung gewährleistet.

Am oberen Ende der Luftlagerwelle 15 ist mit der Antriebsstange 13 drehfest ein Stirnrad 19 verbunden, welches mit einem Ausgangsritzel eines Elektromotors (beide nicht dargestellt) kämmt und über das eine Drehung der Orientierung des Zughakens 7 um die Längsachse der Antriebsstange 13 bewirkt werden kann. Hierdurch lässt sich eine Feinpositionierung des Zughakens bezüglich der zu prüfenden Bondverbindungen auch bei diffizilen geometrischen Konstellationen ausführen. Auch dies dient somit der Erzielung einer hohen Messgenauigkeit und sauber reproduzierbarer Auswertungsergebnisse bei vielgestaltigen Drahtbondverbindungen.

Die Antriebs- bzw. Messstange 13 ist koaxial umgeben von einer Kraftmesseinrichtung 21, die zwei gegensinnig orientierte Kraftmessdosen 23a, 23b üblicher Bauart aufweist. Der unteren Messdose 23b ist eine sogenannte Touch-Down-Feder 25 zum Vorspannen der Antriebsstange 13 und mit ihr des Zughakens 7 in die Ausgangsstellung zugeordnet. Der oberen Messdose 23a ist eine auswechselbare Hauptmessfeder 27 zugeordnet, deren Federkonstante in Abstimmung auf den jeweils zu realisierenden Messbereich ausgewählt wird. Zur Führung der Hauptmessfeder 27 und zugleich zur Bereitstellung einer ersten Abstützfläche für eine Schutzfeder (Softweg-Feder) 29 an der Antriebsstange dient eine erste Federhülse 31. Der obere Bereich der Schutzfeder 29 ist in einer zweiten Federhülse 33 geführt, die ihrerseits in einem Kugellager 35 zum Torsionsschutz der genannten Federn gelagert ist.

Über dem oberen Ende der Antriebs- bzw. Messstange 13 ist eine Gabellichtschranke 37 zur Sicherheitsabschaltung der Testvorrichtung (im Zusammenwirken mit einer nicht dargestellten Auswerteelektronik) angeordnet.

Die oben beschriebene Testvorrichtung wird komplettiert durch (nicht dargestellte) Mittel zur Positionserfassung und -Auswertung des höchsten Punktes der Drahtschlaufe - etwa eine CCD-Kamera mit geeigneter Auflösung und nachgestalteter Auswertungseinrichtung - und einen xy-Tisch zum Verfahren eines Substrates mit der zu prüfenden Drahtschlaufe bezüglich des Zughakens 7 derart, dass dieser unter dem höchsten Punkt der Drahtschlaufe in diese eingreifen kann und daher eine optimale Genauigkeit und Reproduzierbarkeit des Testergebnisses erreicht wird (vgl. hierzu Fig. 3).

### Bezugszeichenliste:

- 1, 3: Bondfläche
- 5: Bonddraht (Loop)
- 5a, 5b: Bondkontakt
- 5c: höchster Punkt der Loop
- 7: Zughaken
- 9: Tragkonstruktion
- 10: xy-Tisch
- 11: Abdeckung
- 13: Antriebsstange (Messstange)
- 15: Luftlagerwelle
- 17: Luftlager
- 19: Stirnrad
- 20: Tischantriebseinheit
- 21: Kraftmesseinrichtung
- 23a, 23b: Kraftmessdosen
- 25: Touch-Down-Feder
- 27: Hauptmessfeder
- 29: Schutzfeder (Softweg-Feder)
- 30: Koordinatensteuerstufe
- 31, 33: Federhülse
- 35: Kugellager
- 37: Gabellichtschranke
- 40: CCD-Kamera
- 50: Bildauswertungseinrichtung
- 60: Motor-Getriebe-Einheit
- 70: Registrierungseinheit
- 80: Mess-Antriebseinheit
- 90: Bewegungssensor (Näherungssensor)
- 100: Steuer- und Erfassungseinheit
- CHIP: Halbleiterschaltkreis
- Lead: Leitung

## Patentansprüche

1. Testvorrichtung zur Ausführung eines Pulltests zur Bestimmung der Zugfestigkeit einer Drahtbondverbindung, die eine Bonddrahtschlaufe (5) zwischen den zwei Bondkontakten (5a, 5b) auf einem Substrat (1, 3; CHIP, Lead) aufweist, mit einem unter die Bonddrahtschlaufe steuerbaren Zughaken (7),
einer mit dem Zughaken verbundenen und eine im wesentlichen senkrecht zur Substratoberfläche ausgerichtete Zugkraft erzeugenden Antriebseinrichtung,
einer dem Zughaken zugeordneten Kraftmesseinrichtung (21) zur Erfassung der momentanen Zugkraft und
einer mit der Kraftmesseinrichtung verbundenen Registriereinrichtung zur Registrierung eines Reißkraftwertes der Drahtbondverbindung, wobei die Kraftmesseinrichtung (21) im wesentlichen koaxial zum Zugkraftvektor (F) angeordnet ist,
**dadurch gekennzeichnet, dass**
Erfassungsmittel (40, 50, 90, 100) zum Erfassen des höchsten Punktes (5c) der Bonddrahtschlaufe und Positionssteuermittel (20, 30) zur selbsttätigen Positionierung des Zughakens und somit des Anfangspunktes des Zugkraftvektors unter den höchsten Punkt der Bonddrahtschlaufe vorgesehen sind, wobei die Erfassungsmittel (90, 100) einen der Antriebseinrichtung (80), und zwar der Antriebsstange (13) des Zughakens (7), zugeordneten Bewegungs- bzw. Näherungssensor (90) zur Erfassung von Bewegungen der Antriebsstange, die sich aus dem Eingriff des Zughakens mit der Bonddrahtschlaufe ergeben, und eine eingangsseitig mit diesem verbundene Steuerund Auswertungseinheit (100) zur Erfassung der Loophöhenwerte einer Mehrzahl von Eingriffspositionen des Zughakens mit der Bonddrahtschlaufe (5) und zur Bestimmung der xy-Koordinaten der Eingriffsposition (5c) mit dem maximalen Höhenwert aufweist.

2. Testvorrichtung nach Anspruch 1,
**dadurch gekennzeichnet, dass**
die Kraftmesseinrichtung (21) mindestens eine koaxial zu einer Antriebsstange des Zughakens angeordnete Kraftmessdose (23a, 23b) aufweist.

3. Testvorrichtung nach Anspruch 2,
**dadurch gekennzeichnet, dass**
die Kraftmesseinrichtung (21) ein Paar von übereinander koaxial zur Antriebsstange des Zughakens angeordneten Kraftmessdosen (23a, 23b) aufweist.

4. Testvorrichtung nach Anspruch 2 oder 3,
**dadurch gekennzeichnet, dass**
die Antriebsstange (13) des Zughakens luftgelagert (15, 17) ist.

5. Testvorrichtung nach einem der vorangehenden Ansprüche,
**gekennzeichnet durch**
eine Motor-Getriebe-Einheit (60) zur Drehung des Zughakens (7) um die Wirkungsrichtung der Antriebseinrichtung (80), d.h. zur Festlegung einer vorbestimmten Winkellage des Zughakens um den Zugkraftvektor (F).

6. Testvorrichtung nach einem der vorangehenden Ansprüche,
**dadurch gekennzeichnet, dass**
die Positionssteuermittel einen xy-Tisch (10, 20, 30) zum koordinatengesteuerten Verfahren des Substrates und damit des höchsten Punktes der Bonddrahtschlaufe bezüglich des Zughakens aufweisen.

7. Testvorrichtung nach einem der vorangehenden Ansprüche,
**dadurch gekennzeichnet, dass**
die Erfassungsmittel (40, 50) eine Kamera (40), deren Gesichtsfeld seitlich auf die Bonddrahtschlaufe (5) ausgerichtet ist, und eine mit der Kamera verbundene Bildauswertungseinrichtung (50) zur Berechnung der Koordinaten des höchsten Punktes (5c) der Bonddrahtschlaufe aus dem Kamerabild aufweist

8. Testvorrichtung nach einem der vorangehenden Ansprüche,
**dadurch gekennzeichnet, dass**
dem Zughaken (7) und der Antriebseinrichtung (80) Federmittel (25 - 29) zum Vorspannen des Zughakens in eine definierte Ausgangsposition sowie zur Dämpfung des Eingriffs zwischen Zughaken und Bonddrahtschlaufe und/oder zur Zugkraftbegrenzung zum Schutz der Kraftmesseinrichtung (21) zugeordnet sind.

9. Testvorrichtung nach Anspruch 8,
**dadurch gekennzeichnet, dass**
die Federmittel (25 - 29) eine erste Feder (25, 27) mit niedriger Federkonstante zum Vorspannen in die Ausgangsposition sowie zur Eingriffs-Dämpfung und eine zweite Feder (29) mit hoher Federkonstante zur Zugkraftbegrenzung umfassen.

10. Testvorrichtung nach Anspruch 9,
**dadurch gekennzeichnet, dass**
die erste und zweite Feder (25 - 29) koaxial zur Antriebsstange des Zughakens angeordnet sind.

## Claims

1. Testing apparatus for carrying out a pull test for determining the tensile strength of a wire bond connection which comprises a bonding wire loop (5) between the two bond contacts (5a, 5b) on a substrate (1, 3; CHIP, Lead),
having a traction hook (7) arranged to be controllably positioned underneath the bonding wire loop,
having a drive device connected to the traction hook and producing a tensile force directed substantially perpendicular to the substrate surface,
having a force-measuring device (21) associated with the traction hook for detecting the instantaneous tensile force and
having a recording device connected to the force-measuring device for recording the value of the breaking force of the wire bond connection,
the force-measuring device (21) being arranged substantially coaxially with the tensile force vector (F),
**characterised in that**
there are provided detection means (40, 50, 90, 100) for detecting the highest point (5c) of the bonding wire loop and position control means (20, 30) for automatically positioning the traction hook - and accordingly the starting point of the tensile force vector - underneath the highest point of the bonding wire loop, the detection means (90, 100) comprising a movement and/or proximity sensor (90) associated with the drive device (80), namely the actuation rod (13) of the traction hook (7), for detecting movements of the actuation rod resulting from engagement of the traction hook with the bonding wire loop, and comprising a control and evaluation unit (100) connected on the input side with that sensor, for detecting loop height values of a plurality of engagement positions of the traction hook with the bonding wire loop (5) and for determining the xy-co-ordinates of the engagement position (5c) having the maximum height value.

2. Testing apparatus according to claim 1,
**characterised in that**
the force-measuring device (21) comprises at least one force-measuring cell (23a, 23b) arranged coaxially with an actuation rod of the traction hook.

3. Testing apparatus according to claim 2,
**characterised in that**
the force-measuring device (21) comprises a pair of force-measuring cells (23a, 23b) arranged, one above the other, coaxially with the actuation rod of the traction hook.

4. Testing apparatus according to claim 2 or 3,
**characterised in that**
the actuation rod (13) of the traction hook has an air bearing (15, 17).

5. Testing apparatus according to one of the preceding claims,
**characterised by**
a motor-gearbox unit (60) for rotation of the traction hook (7) about the direction of action of the drive device (80), that is to say for establishment of a predetermined angular position of the traction hook about the tensile force vector (F).

6. Testing apparatus according to one of the preceding claims,
**characterised in that**
the position control means comprise an xy-table (10, 20, 30) for co-ordinate-controlled movement of the substrate - and accordingly the highest point of the bonding wire loop - relative to the traction hook.

7. Testing apparatus according to one of the preceding claims,
**characterised in that**
the detection means (40, 50) comprise a camera (40), the field of view of which is directed at the bonding wire loop (5) from the side, and an image-evaluating device (50) connected to the camera for calculation of the co-ordinates of the highest point (5c) of the bonding wire loop from the camera image.

8. Testing apparatus according to one of the preceding claims,
**characterised in that**
associated with the traction hook (7) and the drive device (80) are spring means (25 - 29) for biasing the traction hook into a defined starting position and also for damping the engagement between the traction hook and the bonding wire loop and/or for limitation of the tensile force for protection of the force-measuring device (21).

9. Testing apparatus according to claim 8,
**characterised in that**
the spring means (25 - 29) comprise a first spring (25, 27) having a low spring constant for biasing into the starting position and also for engagement damping and a second spring (29) having a high spring constant for tensile force limitation.

10. Testing apparatus according to claim 9,
**characterised in that**
the first and second springs (25 - 29) are arranged coaxially with the actuation rod of the traction hook.

## Revendications

1. Dispositif de test pour la réalisation d'un test de traction afin de déterminer la résistance à la traction d'une connexion par fil, qui comprend
une boucle de fil de connexion (5) entre les deux contacts de connexion (5a, 5b) sur un substrat (1, 3 ; CHIP, Lead), avec un crochet de traction (7) pouvant être piloté sous la boucle de fil de connexion,
un dispositif d'entraînement exerçant une force de traction orientée sensiblement perpendiculairement par rapport à la surface du substrat et reliée au crochet de traction,
un dispositif de mesure des forces (21) associé au crochet de traction, pour mesurer la force de traction instantanée et
un dispositif d'enregistrement, relié au dispositif de mesure des forces, afin d'enregistrer une valeur de force de rupture de la connexion par fil, le dispositif de mesure des forces (21) étant sensiblement coaxial par rapport au vecteur de la force de traction (F),
**caractérisé en ce que** des moyens de mesure (40, 50, 90, 100) sont prévus pour la mesure du point le plus haut (5c) de la boucle de fil de connexion et des moyens de positionnement (20, 30) sont prévus pour le positionnement automatique du crochet de traction et donc du point d'application du vecteur de la force de traction sous le point le plus haut de la boucle de fil de connexion
les moyens de mesure (90, 100) comprenant un capteur de mouvement ou de proximité (90), associé au dispositif d'entraînement (80), et plus particulièrement à la tige d'entraînement (13) du crochet de traction (90), pour la mesure de mouvements de la tige d'entraînement produits par l'accrochage du crochet de traction avec la boucle de fil de connexion, et une unité d'analyse (100), branchée avec celui-ci du côté de l'entrée, pour mesurer les valeurs de hauteur de boucle d'une pluralité de positions d'accrochage du crochet de traction avec la boucle de fil de connexion (5) et pour déterminer les coordonnées xy de la position d'accrochage (5c) avec la valeur de hauteur maximale.

2. Dispositif de test selon la revendication 1, **caractérisé en ce que** le dispositif de mesure des forces (21) comprend au moins un dynamomètre (23a, 23b) coaxial par rapport à une tige d'entraînement du crochet de traction.

3. Dispositif de test selon la revendication 2, **caractérisé en ce que** le dispositif de mesure des forces (21) comprend une paire de dynamomètres (23a, 23b) disposés l'un au-dessus de l'autre coaxialement par rapport à la tige d'entraînement du crochet de traction.

4. Dispositif de test selon la revendication 2 ou 3, **caractérisé en ce que** la tige d'entraînement (13) du crochet de traction est équipée d'un palier pneumatique (15, 17).

5. Dispositif de test selon l'une des revendications précédentes, **caractérisé par** une unité moteur-transmission (60) pour la rotation du crochet de traction (7) autour de la direction d'application du dispositif d'entraînement (80), c'est à dire pour la détermination d'une position angulaire prédéterminée du crochet de traction autour du vecteur de la force de traction (F).

6. Dispositif de test selon l'une des revendications précédentes, **caractérisé en ce que** les moyens de positionnement comprennent une table xy (10, 20, 30) pour le déplacement contrôlé du substrat et donc du point le plus haut de la boucle de fil de connexion par rapport au crochet de traction.

7. Dispositif de test selon l'une des revendications précédentes, **caractérisé en ce que** les moyens de mesure (40, 50) comprennent une caméra (40) dont le champ de vision est orienté latéralement par rapport à la boucle de fil de connexion (5) et un dispositif d'analyse d'image (50), relié à la caméra, pour le calcul des coordonnées du point le plus haut (5c) de la boucle de fil de connexion à partir de l'image de la caméra.

8. Dispositif de test selon l'une des revendications précédentes, **caractérisé en ce que** des moyens élastiques (25 à 29) sont associés au crochet de traction (7) et au dispositif d'entraînement (80), pour la précontrainte du crochet de traction dans une position de départ déterminée ainsi que pour l'amortissement de l'accrochage entre le crochet de traction et la boucle de fil de connexion et/ou pour la limitation de la force de traction afin de protéger le dispositif de mesure de la force de traction (21).

9. Dispositif de test selon la revendication 8, **caractérisé en ce que** les moyens élastiques (25 à 29) comprennent un premier ressort (25, 27) avec une faible constante élastique pour la précontrainte dans une position de départ ainsi que pour l'amortissement de l'accrochage et un deuxième ressort (29) avec une importante constante élastique pour la limitation de la force de traction.

10. Dispositif de test selon la revendication 9, **caractérisé en ce que** le premier et le deuxième ressort (25 à 29) sont coaxiaux à la tige d'entraînement du crochet de traction.
